# EUROPÄISCHE PATENTSCHRIFT

(11) **EP 2 872 910 B1**
(45) Veröffentlichungstag und Bekanntmachung des Hinweises auf die Patenterteilung: **02.08.2017**
(21) Anmeldenummer: 13725305.0
(22) Anmeldetag: 15.05.2013
(51) Int. Cl.: G01R 33/07, G01R 33/00

(54) **HALL-SENSOR**
HALL EFFECT SENSOR
CAPTEUR À EFFET HALL

(30) Priorität: 13.07.2012 DE 102012212272
(43) Veröffentlichungstag der Anmeldung: 20.05.2015
(73) Patentinhaber: Robert Bosch GmbH, 70442 Stuttgart (DE)
(72) Erfinder: KAZMIERCZAK, Harald, 71717 Beilstein (DE); KLOTZBUECHER, Thomas, 73635 Rudersberg (DE)
(86) Internationale Anmeldenummer: PCT/EP2013/060056
(87) Internationale Veröffentlichungsnummer: WO 2014/009043

(56) Entgegenhaltungen:
- DE-A1-102008 000 943
- US-A- 5 218 298
- US-A1- 2007 029 999

## Beschreibung

### Gebiet der Erfindung

Die Erfindung betrifft einen Hall-Sensor.

### Hintergrund der Erfindung

Hall-Sensoren können derart konzipiert werden, dass sie entweder die magnetische Feldstärke oder die Richtung des magnetischen Feldes erfassen können.

Bei Hall-Sensoren, die darauf ausgelegt sind, die Richtung des magnetischen Feldes zu erfassen, können vier Paare von Hall-Sensorelementen auf einem vorgegebenen Radius im Winkel von 90° zueinander angeordnet werden. Die Hall-Sensorelemente sind in Paaren angeordnet, um das Signal-RauschVerhältnis zu verbessern und um die entstehende, in der Regel äußerst geringe Hall-Spannung besser auswerten zu können.

Jedes Paar von Hall-Sensorelementen umfasst zwei parallel angeordnete und parallel geschaltete Hall-Sensorelemente, die mit den Hall-Sensorelementen des gegenüberliegenden Paars korrespondieren. Jedes Paar liefert eine Hall-Spannung in Abhängigkeit des durch die Elemente des Paars fließenden Stroms und der Richtung (bzw. Stärke) des anliegenden magnetischen Feldes. Aus den Hall-Spannungen der Hall-Sensorelemente kann die Richtung des magnetischen Feldes ermittelt werden.

Hat eines der Hall-Sensorelemente einen Defekt, arbeitet der Hall-Sensor nicht mehr zuverlässig. Die Lebensdauer des oben beschriebenen Hall-Sensors bestimmt sich also durch die kürzeste Lebensdauer eines Hall-Sensorelementes. Daher werden häufig zwei redundante Hall-Sensoren eingesetzt. US 2007/029999, D2 US 5 218 298 und DE 10 2008 000943 offenbaren Hall-Sensoren, die relevanten Stand der Technik darstellen.

### Zusammenfassung der Erfindung

Es ist Aufgabe der Erfindung, einen Hall-Sensor mit langer Lebensdauer bereitzustellen.

Diese Aufgabe wird durch den Gegenstand des unabhängigen Anspruchs gelöst. Weitere Ausführungsformen der Erfindung ergeben sich aus den abhängigen Ansprüchen und aus der folgenden Beschreibung.

Ein Aspekt der Erfindung betrifft einen Hall-Sensor zum Erfassen der Richtung eines Magnetfelds.

Gemäß einer Ausführungsform der Erfindung umfasst der Hall-Sensor mehrere in Paaren angeordnete Hall-Sensorelemente, wobei jedes Paar ein erstes Hall-Sensorelement und ein zweites Hall-Sensorelement umfasst, die parallel zueinander angeordnet sind. Der Hall-Sensor weist wenigstens einen ersten Schalter zum Trennen des ersten Hall-Sensorelements von einer Stromversorgung auf. Auch ist es möglich, dass der Schalter dazu ausgeführt ist, das erste Hall-Sensorelement mit der Stromversorgung zu verbinden. Der Schalter kann in einer Zuleitung von der Stromversorgung zu dem Hall-Sensorelement angeordnet sein.

Im Normalbetrieb des Hall-Sensors (d. h. wenn kein Defekt aufgetreten ist oder ermittelt wurde) sind alle Schalter normalerweise geschlossen. Tritt im ersten Hall-Sensorelement ein Defekt auf, kann dieses von der Stromversorgung getrennt werden. Ist das erste Hall-Sensorelement von der Stromversorgung getrennt, liefert es auch bei einem anliegenden Magnetfeld keine Hallspannung mehr, die eventuell durch den Defekt derart verändert ist, dass sie auf ein anderes Magnetfeld hindeutet, was zu einer fehlerhaften Ausgabe des Hall-Sensors führen könnte.

Auf diese Weise kann durch einen einzelnen Hall-Sensor eine Redundanz umgesetzt werden, die bei den eingangs genannten Hall-Sensoren nur mit zwei Hall-Sensoren möglich ist. Ohne zusätzliche Hall-Sensorelemente einzuführen und den Hall-Sensor zu erweitern, kann ein redundanter Hall-Sensor aufgebaut werden.

Gemäß einer Ausführungsform der Erfindung weist der Hall-Sensor einen zweiten Schalter zum Trennen des zweiten Hall-Sensorelements von der Stromversorgung auf. Insbesondere können alle Hall-Sensorelemente getrennt voneinander von der Stromversorgung getrennt werden bzw. mit dieser verbunden werden.

Gemäß einer Ausführungsform der Erfindung umfasst der erste Schalter und/oder der zweite Schalter jeweils zwei Halbleiterschaltelemente, beispielsweise Transistoren, die vor und nach das zugehörige erste Hall-Sensorelement und/oder zweite Hall-Sensorelement geschaltet sind. Die beiden Halbleiterschaltelemente können vor und nach dem Halbleiterschaltelement in einer Zuleitung zu der Stromversorgung angeordnet sein. Werden beide Halbleiterschaltelemente geöffnet, so sind auch parasitäre Kapazitäten von der entsprechenden Zuleitung abgekoppelt.

Die Schalter können MOSFETs umfassen, beispielsweise sind die oben genannten Halbleiterschalter MOSFETs. Die MOSFETs können von einer Steuerung des Hall-Sensors einzeln geschaltet werden.

Gemäß einer Ausführungsform der Erfindung umfasst jedes Paar von Hall-Sensorelementen einen ersten Schalter für ein erstes Hall-Sensorelement und einen zweiten Schalter für ein zweites Hall-Sensorelement. Mit anderen Worten können alle Hall-Sensorelemente unabhängig voneinander bzw. einzeln mit der Stromversorgung verbunden und/oder von dieser getrennt werden.

Gemäß einer Ausführungsform der Erfindung sind die Paare von Hall-Sensorelementen im gleichen Abstand von einem Mittelpunkt angeordnet. Jedes Paar kann zum Mittelpunkt hin ausgerichtet sein. Auf diese Weise kann von zwei gegenüberliegenden Paaren eine Komponente des Magnetfelds erfasst werden. Gemäß einer Ausführungsform der Erfindung umfasst der Hall-Sensor eine Steuerung zum Ermitteln der Richtung des Magnetfelds aus einer Ausgangsspannung der Hall-Sensorelemente. Diese elektronische Steuerung kann auf dem gleichen Chip angeordnet sein wie die Hall-Sensorelemente und deren Schalter. Die Steuerung ist auch dazu ausgeführt, den ersten Schalter, den zweiten Schalter und/oder weitere Schalter anzusteuern, die dazu ausgeführt sind, ein zugehöriges Hall-Sensorelement von der Stromversorgung zu trennen. Beispielsweise kann die Steuerung diese Schalter öffnen und/oder schließen.

Gemäß einer Ausführungsform der Erfindung ist die Steuerung dazu ausgeführt zu ermitteln, ob das erste Hall-Sensorelement und/oder das zweite Hall-Sensorelement einen Defekt aufweist. In diesem Fall, d. h. bei einem ermittelten Defekt, kann die Steuerung das erste Hall-Sensorelement bzw. das defekte Hall-Sensorelement von der Stromversorgung trennen bzw. den zugehörigen Schalter öffnen.

Gemäß einer Ausführungsform der Erfindung ist die Steuerung dazu ausgeführt, ein externes Signal abzugeben, wenn ein Defekt ermittelt wurde. Beispielsweise kann an einen Ausgang des Chips ein Spannungssignal angelegt werden, wenn der Defekt erkannt wurde. Auf diese Weise kann der Hall-Sensor melden, dass er zwar noch in der Lage ist zu arbeiten, aber ausgetauscht werden sollte. Diese Meldung kann an einem entsprechenden Pin des Gehäuses des Chips ausgeben werden.

Die Steuerung kann beispielsweise durch Plausibilität feststellen, ob ein Defekt vorliegt und ob alle Elemente einwandfrei arbeiten. Dies kann durch die Hall-Spannung an den einzelnen Hall-Sensorelementen festgestellt werden, wenn man beispielsweise wohldefinierte Ströme durch die einzelnen Hall-Sensorelemente leitet. Ebenso kann der Spannungsabfall an den Hall-Sensorelementen zur Überprüfung herangezogen werden.

Gemäß einer Ausführungsform der Erfindung ist die Steuerung dazu ausgeführt, einen definierten Strom an das erste Hall-Sensorelement und/oder das zweite Hall-Sensorelement anzulegen und eine ausgegebene Hall-Spannung mit einer definierten Hall-Spannung zu vergleichen, um einen Defekt zu ermitteln. Weicht bei einem vorgegebenen Magnetfeld die ausgegebene Hall-Spannung mehr als einen Toleranzwert von einer zu erwartenden, in der Steuerung definierten Wert ab, arbeitet das Hall-Sensorelement nicht mehr fehlerfrei.

Gemäß einer Ausführungsform der Erfindung ist die Steuerung dazu ausgeführt, einen Spannungsabfall über das erste Hall-Sensorelement und/oder das zweite Hall-Sensorelement zu bestimmen und mit einem definierten Spannungsabfall zu vergleichen. Über den Spannungsabfall kann beispielsweise der Innenwiderstand des Hall-Sensorelements bestimmt werden. Ändert sich der Innenwiderstand, kann das Hall-Sensorelement defekt sein.

Gemäß einer Ausführungsform der Erfindung ist die Steuerung dazu ausgeführt, im Falle eines ermittelten Defekts an einem ersten Hall-Sensorelement aus einem Paar von Hall-Sensorelementen, weitere erste Hall-Sensorelemente aus weiteren Paaren von Hall-Sensorelementen von der Stromversorgung zu trennen. Die Steuerung kann weitere, eventuell nicht defekte Hall-Sensorelemente von der Stromversorgung trennen, um beispielsweise für die Auswertung benötigte Symmetrien in der Anordnung der Hall-Sensorelemente wieder herzustellen. Sollte ein Fehlverhalten festgestellt werden, kann dann durch geeignete Schaltung ein Sensorbetrieb aufrecht erhalten werden.

Gemäß einer Ausführungsform der Erfindung sind die Paare von Hall-Sensorelementen symmetrisch zu einem gemeinsamen Mittelpunkt angeordnet. Die Steuerung ist dazu ausgeführt, ein dem ersten Hall-Sensorelement gegenüberliegendes weiteres erstes Hall-Sensorelement von der Stromversorgung zu trennen. Beispielsweise kann die Steuerung ein erstes Hall-Sensorelement eines gegenüberliegenden Paares von Hall-Sensorelementen von der Stromversorgung trennen, so dass die entsprechende Komponente des Magnetfelds, das die beiden gegenüberliegenden Paare erfassen, nur noch von jeweils einem Hall-Sensorelement erfasst wird.

Gemäß einer Ausführungsform der Erfindung ist die Steuerung dazu ausgeführt, alle ersten Hall-Sensorelemente von der Stromversorgung zu trennen. Auch kann die Steuerung alle ersten Hall-Sensorelemente von der Stromversorgung trennen, so dass nur noch die zweiten Hall-Sensorelemente das Magnetfeld erfassen.

Auf diese Weise wird sich die entsprechende Hall-Spannung in der Regel zwar halbieren, kann aber noch von der Steuerung zuverlässig ausgewertet werden.

Gemäß einer Ausführungsform der Erfindung sind die Hall-Sensorelemente, der erste Schalter, der zweite Schalter und auch weitere entsprechende Schalter zum Trennen der Hall-Sensorelemente von der Stromversorgung und/oder die Steuerung auf einem Halbleiterchip angeordnet. Der Chip kann in einem Kunststoffgehäuse eingegossen sein, das Pins zum Verbinden mit einer Platine umfasst.

Ein weiterer Aspekt der Erfindung betrifft ein Verfahren zum Steuern eines Hall-Sensors, so wie er obenstehend und untenstehend beschrieben wird.

Gemäß einer Ausführungsform der Erfindung umfasst das Verfahren die folgenden Schritte: Ermitteln, ob ein erstes Hall-Sensorelement einen Defekt aufweist; und Trennen des ersten Hall-Sensorelements von der Stromversorgung, wenn ein Defekt an dem ersten Hall-Sensorelement ermittelt wurde.

Weiter kann das Verfahren den Schritt umfassen von Trennen weiterer erster Hall-Sensorelemente aus weiteren Paaren von Hall-Sensorelementen von der Stromversorgung, wenn ein Defekt an dem ersten Hall-Sensorelement ermittelt wurde.

Es ist zu verstehen, dass dieses Verfahren von der oben genannten Steuerung ausgeführt werden kann. Auch ist zu verstehen, dass Merkmale bzw. Funktionen der Steuerung Merkmale des Verfahrens sein können und umgekehrt.

### Kurze Beschreibung der Figuren

Im Folgenden werden Ausführungsbeispiele der Erfindung mit Bezug auf die beiliegenden Figuren detailliert beschrieben.
Die Fig. 1 zeigt eine schematische Ansicht eines Hall-Sensorelements für einen Hall-Sensor gemäß einer Ausführungsform der Erfindung.
Die Fig. 2 zeigt eine Ansicht eines Halbleiter-Chips von oben mit einem Hall-Sensor gemäß einer Ausführungsform der Erfindung.
Die Fig. 3 zeigt eine schematische dreidimensionale Ansicht eines Ausschnitts aus der Fig. 2.
Die Fig. 4 zeigt schematisch eine Anordnung von Hall-Sensorelementen für einen Hall-Sensor gemäß einer Ausführungsform der Erfindung.
Die Fig. 5 zeigt schematisch ein Paar von Hall-Sensorelementen für einen Hall-Sensor gemäß einer Ausführungsform der Erfindung.

Grundsätzlich sind identische oder ähnliche Teile mit den gleichen Bezugszeichen versehen.

### Detaillierte Beschreibung von Ausführungsbeispielen

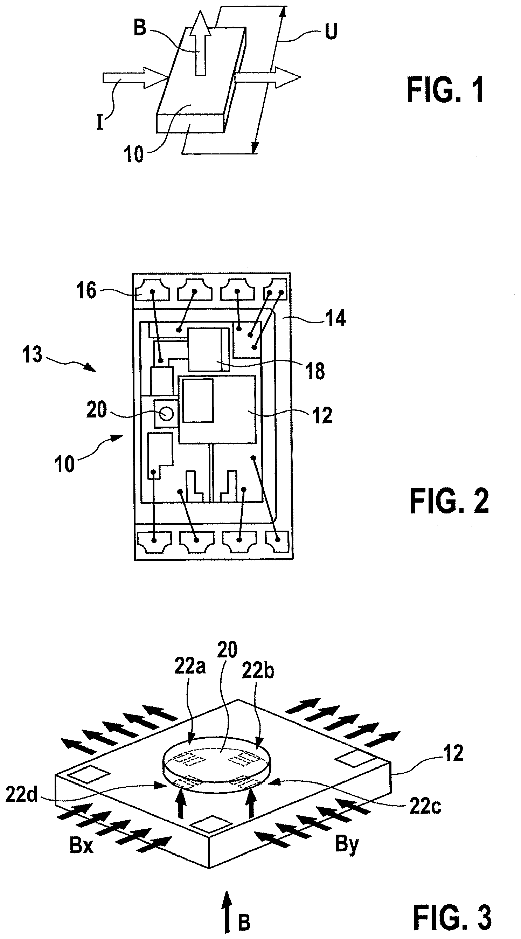

Fig. 1 erläutert die Funktionsweise eines Hall-Sensorelements 10. Wenn das Hall-Sensorelement 10 von einem Strom I durchflossen wird und das Hall-Sensorelement von einem Magnetfeld B durchdrungen wird, das orthogonal zum Strom I steht, entsteht an den Enden des Hall-Sensorelements 10, die orthogonal zum Strom I und dem Magnetfeld B angeordnet sind, eine Hall-Spannung U. Die Hall-Spannung ist proportional zum Vektorprodukt aus Strom I und Magnetfeld B.

Fig. 2 zeigt einen Halbleiter-Chip 12, auf dem sich ein Hall-Sensor 13 mit einer Mehrzahl von Hall-Sensorelementen 10 befindet. Der Chip 12 ist von einem Kunststoff-Gehäuse 14 umgeben, an dem auch mehrere Pins 16 befestigt sind, die mit den Ein- und Ausgängen des Chips 12 verbunden sind. Auf dem Chip 12 ist auch eine elektronische Steuerung 18 angeordnet, die dazu ausgeführt ist, die Hall-Sensorelemente 10 anzusteuern und deren Hall-Spannung auszuwerten.

Die Hall-Sensorelemente 10 befinden sich unter einem Flux-Konzentrator 20, der in der Fig. 3 im Detail gezeigt ist. In der Fig. 3 ist zu erkennen, dass vier Paare 22a, 22b, 22c, 22d von Hall-Sensorelementen unter dem Flux-Konzentrator 20 auf dem Chip 12 angeordnet sind. Die Komponenten Bₓ und B_{y} eines Magnetfelds B, dass parallel zu der Oberfläche des Chips 12 verläuft, werden von dem Flux-Konzentrator 20 in eine Richtung orthogonal zur Oberfläche des Chips 12 abgelenkt, so dass die Hall-Sensorelemente auch die Komponenten Bₓ und B_{y} erfassen können.

In den Figuren ist ein zweidimensionaler Hall-Sensor 13 gezeigt. Es ist jedoch auch möglich, dass die Erfindung auf einen dreidimensionalen Hall-Sensor angewendet wird.

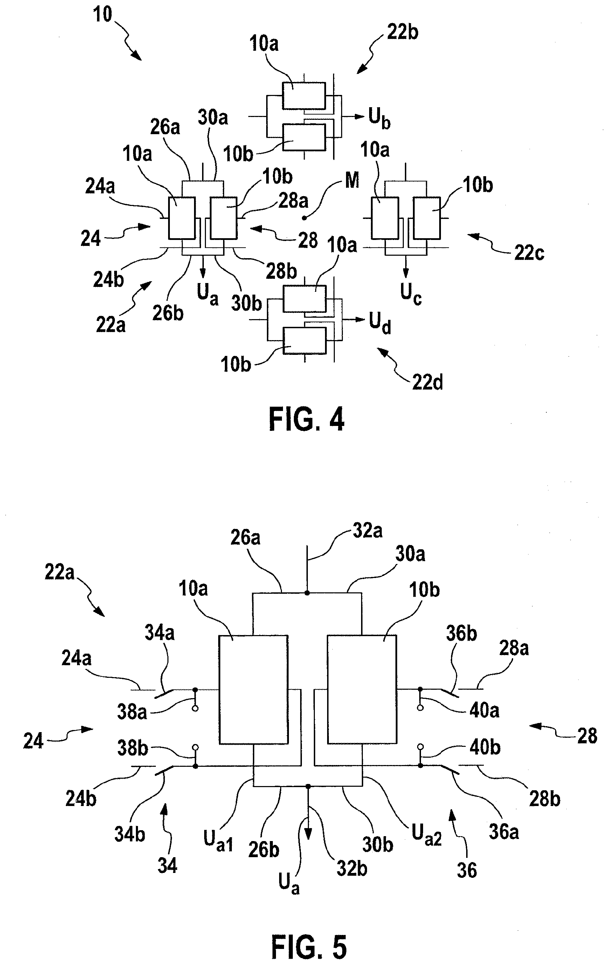

Die Fig. 4 zeigt die Anordnung der Paare 22a, 22b, 22c, 22d unter dem Flux-Konzentrator 20. Die Paare 22a, 22b, 22c, 22d sind im gleichen Abstand von einem Mittelpunkt M angeordnet und umfassen jeweils zwei parallel zueinander angeordnete Hall-Sensorelemente 10a, 10b. Außerdem sind die Paar 22a, 22b, 22c, 22d zum Mittelpunkt M hin ausgerichtet, d. h. die Seiten der Hall-Sensorelemente 10a, 10b, an denen eine Hall-Spannung abgegriffen wird, zeigen tangential zu einem Kreis um den Mittelpunkt M.

Die Fig. 5 zeigt das Paar 22a von Hall-Sensorelementen 10a, 10b. Es ist zu verstehen, dass die anderen Paare 22b, 22c, 22d genauso wie das Paar 22a aufgebaut sein können und in analoger Art und Weise mit der Steuerung 18 verbunden sind.

Das Hall-Sensorelement 10a umfasst eine Stromversorgung 24 mit zwei Zuleitungen 24a, 24b für Strom und zwei Ausgänge bzw. Ausgangsleitungen 26a, 26b, an den die Hall-Spannung Uₐ₁ des Hall-Sensorelements 10a anliegt. In analoger Weise umfasst das Hall-Sensorelement 10b eine Stromversorgung 28 mit zwei Zuleitungen 28a, 28b und zwei Ausgangsleitungen 30a, 30b für die Hall-Spannung Uₐ₂.

Die Zuleitungen 24a, 24b, 26a, 26b können mit einer gemeinsamen Stromversorgung verbunden sein, beispielsweise direkt mit zwei Pins 16 des Gehäuses 14, an denen ein Versorgungstrom für den Chip 12 anliegt.

Die Hall-Sensorelemente 10a, 10b sind bezüglich der Ausgangsleitungen 26a, 26b, 30a, 30b parallel geschaltet, so dass das Paar 22a lediglich zwei Ausgangsleitungen 32a, 32b für die Hall-Spannung Uₐ aufweist, die mit der Steuerung 18 verbunden sind. Am Ausgang 32a, 32b des Paars 22a liegt somit die Summe der Hall-Spannungen Uₐ₁, Uₐ₂ der Hall-Sensorelemente 10a, 10b an. Die Paare 22b, 22c, 22d geben entsprechende Hall-Spannungen U_{b}, U_{c} und U_{d} ab.

Die Stromversorgung 24 des Hall-Sensorelements 10a kann durch einen Schalter 34 vom Hall-Sensorelement 10a getrennt werden. Der Schalter 34 umfasst dabei zwei Halbleiterschaltelemente 34a, 34b, die jeweils in der Zuleitung 24a, 24b angeordnet sind und somit vor und nach das Hall-Sensorelement 10a geschaltet sind. Die beiden Halbleiterschaltelemente 34a, 34b können von der Steuerung 18 geöffnet und geschlossen werden.

In analoger Weise kann die Stromversorgung 28 des Hall-Sensorelements 10b mit einem Schalter 36, der zwei Halbleiterschaltelemente 36a, 36b umfasst, von dem Hall-Sensorelement 10 getrennt bzw. mit diesem verbunden werden.

Weiter sind die Zuleitungen 24a, 24b des Hall-Sensorelements 10 mit zwei Messleitungen 38a, 38b verbunden, über die die Steuerung eine Spannung am Hall-Sensorelement 10a ermitteln kann. Die Messleitungen 38a, 38b sind innerhalb der Schaltelemente 34a, 34b angebracht. Die Zuleitungen 28a, 28b des Hall-Sensorelements 10b sind mit zwei analogen Messleitungen 40a, 40b verbunden.

Im Normalbetrieb, wenn kein Defekt vorliegt, sind alle Schalter 34, 36 bzw. alle Schaltelemente 34a, 34b, 36a, 36b aller Hall-Sensorelemente 10a, 10b aller Paare 22a, 22b, 22c, 22d geschlossen.

Im Normalbetrieb ermittelt die Steuerung 18 die Richtung eines Magnetfelds B, dem der Hall-Sensor ausgesetzt ist, aus den Hall-Spannungen Uₐ, U_{b}, U_{c}, U_{d} an den Paaren 22a, 22b, 22c, 22d, die jeweils die Summe der einzelnen Hall-Spannungen der Hall-Sensorelemente 10a, 10b darstellen.

In regelmäßigen Abständen ermittelt die Steuerung 18 nun, ob eines der Hall-Sensorelemente 10a, 10b aller Paare 22a, 22b, 22c, 22d einen Defekt aufweist.

Dazu gibt es mehrere Möglichkeiten. Die Steuerung 18 kann beispielsweise einen definierten Strom an die Leitungen 24a, 24b (bzw. 28a, 28b) des Hall-Sensorelements 10a (bzw. 10b) anlegen und dabei das zweite Hall-Sensorelement 10b (bzw. 10a) von seiner Stromversorgung trennen und eine ausgegebene Hall-Spannung mit einer definierten Hall-Spannung vergleichen. Auch ist es möglich, dass die Steuerung 18 mittels der Messleitungen 38a, 38b (bzw. 40a, 40b) einen Spannungsabfall über das Hall-Sensorelement 10a (bzw. 10b) bestimmt und mit einem vordefinierten Wert vergleicht.

Ermittelt die Steuerung einen Defekt in einem Hall-Sensorelement 10a, 10b gibt sie über einen der Pins 16 ein externes Signal aus.

Weiter werden das defekte Hall-Sensorelement und eventuell weitere Hall-Sensorelemente deaktiviert und von der Stromversorgung getrennt.

Wenn beispielsweise das Hall-Sensorelement 10a des Paares 22a defekt ist, könnte die Stromversorgung zusätzlich das Hall-Sensorelement 10a des gegenüberliegenden Paares 22c deaktivieren. In diesem Fall wird die Richtung des Magnetfelds aus den Hallspannungen U_{b} und U_{d} der ersten und zweiten Hall-Sensorelemente 10a, 10b der Paare 22b und 22d und den Hall-Spannungen Uₐ und U_{c} der zweiten Hall-Sensorelemente 10b der Paare 22a und 22b ermittelt.

Auch könnten im Falle eines Defekts des Hall-Sensorelements 10a des Paares 22a alle ersten Sensorelemente 10a aller Paare 22a, 22b, 22c, 22d deaktiviert werden. In diesem Falle wird die Richtung des Magnetfelds B nur noch durch die Hall-Spannungen der zweiten Sensorelemente 10b ermittelt. Wenn bei allen Paaren 22a, 22b, 22c, 22d lediglich ein Sensorelement 10b verwendet wird, kürzt sich die Amplitude der Spannung heraus (Cordic-Algorithmus).

Ergänzend ist darauf hinzuweisen, dass "umfassend" keine anderen Elemente oder Schritte ausschließt und "eine" oder "ein" keine Vielzahl ausschließt. Ferner sei darauf hingewiesen, dass Merkmale oder Schritte, die mit Verweis auf eines der obigen Ausführungsbeispiele beschrieben worden sind, auch in Kombination mit anderen Merkmalen oder Schritten anderer oben beschriebener Ausführungsbeispiele verwendet werden können. Bezugszeichen in den Ansprüchen sind nicht als Einschränkung anzusehen.

## Patentansprüche

1. Hall-Sensor (10) zum Erfassen der Richtung eines Magnetfelds (B), der Hall-Sensor (10) umfassend:
mehrere in Paaren (22a, 22b, 22c, 22d) angeordnete Hall-Sensorelemente (10a, 10b), wobei jedes Paar ein erstes Hall-Sensorelement (10a) und ein zweites Hall-Sensorelement (10b) umfasst, die parallel geschaltet sind, wobei der Hall-Sensor (10) einen ersten Schalter (34) zum Trennen des ersten Hall-Sensorelements (10a) von einer Stromversorgung (24) aufweist,
**dadurch gekennzeichnet, dass**
in einem Normalbetrieb die Richtung eines Magnetfelds (B), dem der Hall-Sensor ausgesetzt ist, ermittelt wird aus den Hall-Spannungen (Uₐ, U_{b}, U_{c}, U_{d}) an den Paaren (22a, 22b, 22c, 22d), die jeweils die Summe der einzelnen Hall-Spannungen der Hall-Sensorelemente (10a, 10b) darstellen und wobei der Hall-Sensor eingerichtet ist zum Ermitteln, ob ein erstes Hall-Sensorelement (10a) einen Defekt aufweist und zum Trennen des ersten Hall-Sensorelements (10a) von einer Stromversorgung (24), wenn ein Defekt an dem ersten Hall-Sensorelement (10a) ermittelt wurde.

2. Hall-Sensor (10) nach Anspruch 1,wobei
die Hall-Sensorelemente (10a, 10b) eines Paares (22a, 22b, 22c, 22d) bezüglich der Ausgangsleitungen (26a, 26b, 30a, 30b) derart parallel geschaltet sind, dass das Paar (22a, 22b, 22c, 22d) lediglich zwei Ausgangsleitungen (32a, 32b) für die Hall-Spannung Uₐ aufweist.

3. Hall-Sensor (10) nach Anspruch 1 oder 2,
wobei der Hall-Sensor (10) vier Paare (22a, 22b, 22c, 22d) von Hall-Sensorelementen (10a, 10b) aufweist.

4. Hall-Sensor (10) nach einem der vorhergehenden Ansprüche,
wobei der Hall-Sensor (10) als Halbleiter-Chip ausgebildet ist.

5. Hall-Sensor (10) nach einem der vorhergehenden Ansprüche,
wobei der Hall-Sensor (10) einen zweiten Schalter (36) zum Trennen des zweiten Hall-Sensorelements (10b) von einer Stromversorgung (28) aufweist.

6. Hall-Sensor (10) nach einem der vorhergehenden Ansprüche,
wobei der erste Schalter (34) und/oder der zweite Schalter (36) jeweils zwei Halbleiterschaltelemente (34a, 34b; 36a, 36b) umfasst, die vor und nach das zugehörige erste Hall-Sensorelement (10a) und/oder zweiten Hall-Sensorelement (10b) geschaltet sind.

7. Hall-Sensor (10) nach einem der vorhergehenden Ansprüche,
wobei jedes Paar (22a, 22b, 22c, 22d) von Hall-Sensorelementen (10, 10b) einen ersten Schalter (34) für ein erstes Hall-Sensorelement (10a) und einen zweiten Schalter (36) für ein zweites Hall-Sensorelement (10b) umfasst.

8. Hall-Sensor (10) nach einem der vorhergehenden Ansprüche,
wobei die Paare (22a, 22b, 22c, 22d) von Hall-Sensorelementen (10a, 10b) im gleichen Abstand von einem Mittelpunkt (M) angeordnet sind und jedes Paar zum Mittelpunkt hin ausgerichtet ist.

9. Hall-Sensor (10) nach einem der vorhergehenden Ansprüche, weiter umfassend:
eine Steuerung (18) zum Ermitteln der Richtung des Magnetfelds (B) aus einer Ausgangsspannung der Hall-Sensorelemente,
wobei die Steuerung (18) dazu ausgeführt ist, den ersten Schalter (34) anzusteuern.

10. Hall-Sensor (10) nach Anspruch 9,
wobei die Steuerung (18) dazu ausgeführt ist zu ermitteln, ob das erste Hall-Sensorelement (10a) und/oder das zweite Hall-Sensorelement (10b) einen Defekt aufweist.

11. Hall-Sensor (10) nach Anspruch 9 oder 10,
wobei die Steuerung (18) zum Ermitteln des Defekts dazu ausgeführt ist, einen definierten Strom an das erste Hall-Sensorelement (10a) und/oder das zweite Hall-Sensorelement (10b) anzulegen und eine ausgegebene Hall-Spannung mit einer definierten Hall-Spannung zu vergleichen.

12. Hall-Sensor (10) nach einem der Ansprüche 9 bis 11,
wobei die Steuerung (18) zum Ermitteln des Defekts dazu ausgeführt ist, einen Spannungsabfall über das erste Hall-Sensorelement (10) und/oder das zweite Hall-Sensorelement (10b) zu bestimmen und mit einem definierten Spannungsabfall zu vergleichen.

13. Hall-Sensor (10) nach einem der Ansprüche 9 bis 12,
wobei die Steuerung (18) dazu ausgeführt ist, ein externes Signal abzugeben, wenn ein Defekt ermittelt wurde.

14. Hall-Sensor (10) nach einem der Ansprüche 9 bis 12,
wobei die Steuerung dazu ausgeführt ist, im Falle eines ermittelten Defekts an dem ersten Hall-Sensorelement (10a), weitere erste Hall-Sensorelemente (10a) aus weiteren Paaren von Hall-Sensorelementen von der Stromversorgung (24) zu trennen.

15. Hall-Sensor (10) nach Anspruch 14.,
wobei die Paare (22a, 22b, 22c, 22d) von Hall-Sensorelementen symmetrisch zu einem gemeinsamen Mittelpunkt angeordnet sind und die Steuerung dazu ausgeführt ist, ein dem ersten Hall-Sensorelement (10a) gegenüberliegendes weiteres erstes Hall-Sensorelement (10a) von der Stromversorgung (24) zu trennen.

16. Hall-Sensor (10) nach Anspruch 14,
wobei die Steuerung dazu ausgeführt ist, alle ersten Hall-Sensorelemente (10a) von der Stromversorgung (24) zu trennen.

17. Hall-Sensor (10) nach einem der vorhergehenden Ansprüche,
wobei die Hall-Sensorelemente (10a, 10b), Schalter (34, 36) zum Trennen der Hall-Sensorelemente von der Stromversorgung (24, 28) und eine Steuerung (18) auf einem Halbleiterchip (12) angeordnet sind.

18. Verfahren zum Steuern eines Hall-Sensors (10), der mehrere in Paaren (22a, 22b, 22c, 22d) angeordnete Hall-Sensorelemente (10a, 10b) umfasst, wobei jedes Paar ein erstes Hall-Sensorelement (10a) und ein zweites Hall-Sensorelement (10b) umfasst, die parallel zueinander geschaltet sind,
wobei der Hall-Sensor (10) einen ersten Schalter (34) zum Trennen des ersten Hall-Sensorelements (10a) von einer Stromversorgung (24) aufweist,
wobei in einem Normalbetrieb die Richtung eines Magnetfelds (B), dem der Hall-Sensor ausgesetzt ist, ermittelt wird aus den Hall-Spannungen (Uₐ, U_{b}, U_{c}, U_{d}) an den Paaren (22a, 22b, 22c, 22d), die jeweils die Summe der einzelnen Hall-Spannungen der Hall-Sensorelemente (10a, 10b) darstellen,
wobei das Verfahren die folgenden Schritte umfasst:
Ermitteln, ob ein erstes Hall-Sensorelement (10a) einen Defekt aufweist;
Trennen des ersten Hall-Sensorelements (10a) von einer Stromversorgung (24), wenn ein Defekt an dem ersten Hall-Sensorelement (10a) ermittelt wurde.

## Claims

1. Hall sensor (10) for detecting the direction of a magnetic field (B), the Hall sensor (10) comprising:
a plurality of Hall sensor elements (10a, 10b) arranged in pairs (22a, 22b, 22c, 22d), wherein each pair comprises a first Hall sensor element (10a) and a second Hall sensor element (10b), which are connected in parallel,
wherein the Hall sensor (10) has a first switch (34) for disconnecting the first Hall sensor element (10a) from a power supply (24),
**characterized in that**
in normal operation the direction of a magnetic field (B) to which the Hall sensor is exposed is determined from the Hall voltages (Uₐ, U_{b}, U_{c}, U_{d}) at the pairs (22a, 22b, 22c, 22d), which constitute in each case the sum of the individual Hall voltages of the Hall sensor elements (10a, 10b), and wherein the Hall sensor is configured for determining whether a first Hall sensor element (10a) has a defect and for disconnecting the first Hall sensor element (10a) from a power supply (24) if a defect was determined on the first Hall sensor element (10a).

2. Hall sensor (10) according to Claim 1, wherein
the Hall sensor elements (10a, 10b) of a pair (22a, 22b, 22c, 22d) are connected in parallel with respect to the output lines (26a, 26b, 30a, 30b) in such a way that the pair (22a, 22b, 22c, 22d) has only two output lines (32a, 32b) for the Hall voltage Uₐ.

3. Hall sensor (10) according to Claim 1 or 2,
wherein the Hall sensor (10) has four pairs (22a, 22b, 22c, 22d) of Hall sensor elements (10a, 10b).

4. Hall sensor (10) according to any of the preceding claims,
wherein the Hall sensor (10) is embodied as a semiconductor chip.

5. Hall sensor (10) according to any of the preceding claims,
wherein the Hall sensor (10) has a second switch (36) for disconnecting the second Hall sensor element (10b) from a power supply (28).

6. Hall sensor (10) according to any of the preceding claims,
wherein the first switch (34) and/or the second switch (36) comprise(s) in each case two semiconductor switching elements (34a, 34b; 36a, 36b) connected upstream and downstream of the associated first Hall sensor element (10a) and/or second Hall sensor element (10b).

7. Hall sensor (10) according to any of the preceding claims,
wherein each pair (22a, 22b, 22c, 22d) of Hall sensor elements (10a, 10b) comprises a first switch (34) for a first Hall sensor element (10a) and a second switch (36) for a second Hall sensor element (10b).

8. Hall sensor (10) according to any of the preceding claims,
wherein the pairs (22a, 22b, 22c, 22d) of Hall sensor elements (10a, 10b) are arranged at the same distance from a centre point (M) and each pair is aligned towards the centre point.

9. Hall sensor (10) according to any of the preceding claims, further comprising:
a controller (18) for determining the direction of the magnetic field (B) from an output voltage of the Hall sensor elements,
wherein the controller (18) is designed to drive the first switch (34).

10. Hall sensor (10) according to Claim 9,
wherein the controller (18) is designed to determine whether the first Hall sensor element (10a) and/or the second Hall sensor element (10b) have/has a defect.

11. Hall sensor (10) according to Claim 9 or 10,
wherein the controller (18) for determining the defect is designed to apply a defined current to the first Hall sensor element (10a) and/or the second Hall sensor element (10b) and to compare a Hall voltage that is output with a defined Hall voltage.

12. Hall sensor (10) according to any of Claims 9 to 11,
wherein the controller (18) for determining the defect is designed to ascertain a voltage drop across the first Hall sensor element (10a) and/or the second Hall sensor element (10b) and to compare it with a defined voltage drop.

13. Hall sensor (10) according to any of Claims 9 to 12,
wherein the controller (18) is designed to output an external signal if a defect was determined.

14. Hall sensor (10) according to any of Claims 9 to 12,
wherein the controller is designed, in the case of a defect determined on the first Hall sensor element (10a), to disconnect further first Hall sensor elements (10a) from further pairs of Hall sensor elements from the power supply (24).

15. Hall sensor (10) according to Claim 14,
wherein the pairs (22a, 22b, 22c, 22d) of Hall sensor elements are arranged symmetrically with respect to a common centre point and the controller is designed to disconnect a further first Hall sensor element (10a) situated opposite the first Hall sensor element (10a) from the power supply (24).

16. Hall sensor (10) according to Claim 14,
wherein the controller is designed to disconnect all first Hall sensor elements (10a) from the power supply (24).

17. Hall sensor (10) according to any of the preceding claims,
wherein the Hall sensor elements (10a, 10b), switches (34, 36) for disconnecting the Hall sensor elements from the power supply (24, 28) and a controller (18) are arranged on a semiconductor chip (12).

18. Method for controlling a Hall sensor (10) comprising
a plurality of Hall sensor elements (10a, 10b) arranged in pairs (22a, 22b, 22c, 22d), wherein each pair comprises a first Hall sensor element (10a) and a second Hall sensor element (10b), which are connected in parallel,
wherein the Hall sensor (10) has a first switch (34) for disconnecting the first Hall sensor element (10a) from a power supply (24),
wherein in normal operation the direction of a magnetic field (B) to which the Hall sensor is exposed is determined from the Hall voltages (Uₐ, U_{b}, U_{c}, U_{d}) at the pairs (22a, 22b, 22c, 22d), which constitute in each case the sum of the individual Hall voltages of the Hall sensor elements (10a, 10b),
wherein the method comprises the following steps:
determining whether a first Hall sensor element (10a) has a defect;
disconnecting the first Hall sensor element (10a) from a power supply (24) if a defect was determined on the first Hall sensor element (10a).

## Revendications

1. Capteur à effet Hall (10) destiné à détecter la direction d'un champ magnétique (B), le capteur à effet Hall (10), comprenant :
plusieurs éléments capteurs à effet Hall (10a, 10b) disposés par paires (22a, 22b, 22c, 22d), dans lequel chaque paire comprend un premier élément capteur à effet Hall (10a) et un deuxième élément capteur à effet hall (10b) qui sont connectés en parallèle,
dans lequel le capteur à effet Hall (10) comporte un premier commutateur (34) destiné à séparer le premier élément capteur à effet Hall (10a) d'une alimentation en courant (24),
**caractérisé en ce que**, lors d'un fonctionnement normal, la direction d'un champ magnétique (B) auquel est exposé le capteur à effet Hall est déterminée à partir des tensions Hall (Uₐ, U_{b}, U_{c}, U_{d}) au niveau des paires (22a, 22b, 22c, 22d), qui représentent respectivement la somme des tensions Hall individuelles des éléments capteurs à effet Hall (10a, 10b) et dans lequel le capteur à effet Hall est conçu pour déterminer si un premier élément capteur à effet Hall (10a) présente un défaut et pour séparer le premier élément capteur à effet Hall (10a) d'une alimentation en courant (24) lorsqu'un défaut a été détecté sur le premier élément capteur à effet Hall (10a).

2. Capteur à effet Hall (10) selon la revendication 1,
dans lequel les éléments capteurs à effet Hall (10a, 10b) d'une paire (22a, 22b, 22c, 22d) par rapport aux lignes de sortie (26a, 26b, 30a, 30b) sont connectés en parallèle de manière à ce que la paire (22a, 22b, 22c, 22d) ne présente que deux lignes de sortie (32a, 32b) pour la tension Hall Uₐ.

3. Capteur à effet Hall (10) selon la revendication 1 ou 2,
dans lequel le capteur à effet Hall (10) comporte quatre paires (22a, 22b, 22c, 22d) d'éléments capteurs à effet Hall (10a, 10b).

4. Capteur à effet Hall (10) selon l'une quelconque des revendications précédentes,
dans lequel le capteur à effet Hall (10) est réalisé sous la forme d'une puce à semi-conducteur.

5. Capteur à effet Hall (10) selon l'une quelconque des revendications précédentes,
dans lequel le capteur à effet Hall (10) comporte un deuxième commutateur (36) destiné à séparer le deuxième élément capteur à effet Hall (10b) d'une alimentation en courant (28).

6. Capteur à effet Hall (10) selon l'une quelconque des revendications précédentes,
dans lequel le premier commutateur (34) et/ou le deuxième commutateur (36) comprend/comprennent respectivement deux éléments de commutation à semi-conducteur (34a, 34b ; 36a, 36b) qui sont connectés en amont et en aval du premier élément capteur à effet Hall (10a) et/ou deuxième élément capteur à effet Hall (10b) associé(s).

7. Capteur à effet Hall (10) selon l'une quelconque des revendications précédentes,
dans lequel chaque paire (22a, 22b, 22c, 22d) d'éléments capteurs à effet Hall (10, 10b) comprend un premier commutateur (34) destiné à un premier élément capteur à effet Hall (10a) et un deuxième commutateur (36) destiné à un deuxième élément capteur à effet Hall (10b).

8. Capteur à effet Hall (10) selon l'une quelconque des revendications précédentes,
dans lequel les paires (22a, 22b, 22c, 22d) d'éléments capteurs à effet Hall (10a, 10b) sont disposées à la même distance d'un point central (M) et dans lequel chaque paire est orientée vers le point central.

9. Capteur à effet Hall (10) selon l'une quelconque des revendications précédentes,
comprenant en outre une unité de commande (18) destinée à déterminer la direction du champ magnétique (B) à partir d'une tension de sortie des éléments capteurs à effet Hall,
dans lequel l'unité de commande (18) est conçue pour commander le premier commutateur (34).

10. Capteur à effet Hall (10) selon la revendication 9,
dans lequel l'unité de commande (18) est conçue pour déterminer si le premier élément capteur à effet Hall (10a) et/ou le deuxième élément capteur à effet Hall (10b) présente/présentent un défaut.

11. Capteur à effet Hall (10) selon la revendication 9 ou 10,
dans lequel, pour la détermination du défaut, l'unité de commande (18) est conçue de manière à appliquer un courant défini au premier élément capteur à effet Hall (10a) et/ou au deuxième élément capteur à effet Hall (10b) et pour comparer une tension Hall fournie en sortie à une tension Hall définie.

12. Capteur à effet Hall (10) selon l'une quelconque des revendications 9 à 11,
dans lequel, pour la détermination du défaut, l'unité de commande (18) est conçue pour déterminer une chute de tension aux bornes du premier élément à effet Hall (10a) et/ou du deuxième élément à effet Hall (10b) et pour la comparer à une chute de tension définie.

13. Capteur à effet Hall (10) selon l'une quelconque des revendications 9 à 12,
dans lequel l'unité de commande (18) est conçue pour fournir en sortie un signal externe lorsqu'un défaut a été déterminé.

14. Capteur à effet Hall (10) selon l'une quelconque des revendications 9 à 12,
dans lequel, dans le cas où un défaut a été déterminé sur le premier élément capteur à effet Hall (10a), l'unité de commande est conçue pour séparer d'autres premiers éléments capteurs à effet Hall (10a) d'autres paires d'éléments capteurs à effet Hall de l'alimentation en courant (24).

15. Capteur à effet Hall (10) selon la revendication 14,
dans lequel les paires (22a, 22b, 22c, 22d) d'éléments capteurs à effet Hall sont disposées symétriquement par rapport à un point central commun et dans lequel l'unité de commande est conçue pour séparer un autre premier élément capteur à effet Hall (10a) opposé au premier élément capteur à effet Hall (10a), de l'alimentation en courant (24).

16. Capteur à effet Hall (10) selon la revendication 14,
dans lequel l'unité de commande est conçue pour séparer tous les premiers éléments capteurs à effet Hall (10a) de l'alimentation en courant (24).

17. Capteur à effet Hall (10) selon l'une quelconque des revendications précédentes,
dans lequel les éléments capteurs à effet Hall (10a, 10b), les commutateurs (34, 36) destinés à séparer les éléments capteurs à effet Hall de l'alimentation en courant (24, 28) et une unité de commande (18) sont disposés sur une puce à semi-conducteur (12).

18. Procédé de commande d'un capteur à effet Hall (10) comprenant plusieurs capteurs à effet Hall (10a, 10b) disposés par paires (22a, 22b, 22c, 22d), dans lequel chaque paire comprend un premier élément capteur à effet Hall (10a) et un deuxième élément capteur à effet hall (10b) qui sont connectés l'un à l'autre en parallèle,
dans lequel le capteur à effet Hall (10) comporte un premier commutateur (34) destiné à séparer le premier élément capteur à effet Hall (10a) d'une alimentation en courant (24),
dans lequel, lors d'un fonctionnement normal, la direction d'un champ magnétique (B) auquel est exposé le capteur à effet Hall est déterminée à partir des tensions Hall (Uₐ, U_{b}, U_{c}, U_{d}) au niveau des paires (22a, 22b, 22c, 22d), qui représentent respectivement la somme des tensions Hall individuelles des éléments capteurs à effet Hall (10a, 10b),
dans lequel le procédé comprend les étapes consistant à :
déterminer si un premier élément capteur à effet Hall (10a) présente un défaut ;
séparer le premier élément capteur à effet Hall (10a) d'une alimentation en courant (24) lorsqu'un défaut a été détecté sur le premier élément capteur à effet Hall (10a).
